(19) Europäisches Patentamt

European Patent Office

Office européen des brevets

(11) Veröffentlichungsnummer : **0 493 307 A2**

(12) **EUROPÄISCHE PATENTANMELDUNG**

(21) Anmeldenummer : **91710055.4**

(22) Anmeldetag : **21.12.91**

(51) Int. Cl.⁵ : **H01L 27/142, H01L 31/04**

(30) Priorität : **28.12.90 DE 4042014**

(43) Veröffentlichungstag der Anmeldung :
**01.07.92 Patentblatt 92/27**

(84) Benannte Vertragsstaaten :
**AT BE CH DE DK ES FR GB GR IT LI LU MC NL SE**

(71) Anmelder : **Raupach, Peter, Dipl.-Volkswirt.**
**Nordendstrasse 59**
**W-8000 München 40 (DE)**

(72) Erfinder : **Dorison, Andreas**
**Gründlacher Strasse 1**
**W-8520 Erlangen (DE)**
Erfinder : **Wecker, Reinhard**
**Am Nussbuck 25**
**W-8521 Möhrendorf (DE)**
Erfinder : **Ganter, Hans-Peter**
**Alfred-Kolping-Strasse 11**
**W-8600 Bamberg (DE)**

(74) Vertreter : **Hiebsch, Gerhard F., Dipl.-Ing.**
**Hiebsch & Peege Patentanwälte Postfach 464**
**Erzbergerstrasse 5a**
**W-7700 Singen 1 (DE)**

(54) **Photovoltaisches Element und dessen Verwendung sowie Verfahren und Vorrichtung zu seiner Herstellung.**

(57)   Ein photovoltaisches Element mit zwischen zwei Schichten vorgesehener Sperrschicht zum Trennen darin entstandener oder in sie eindiffundierter Ladungsträgerpaare od. dgl., das auf einem Träger (64) aus elastischem oder flexiblem Werkstoff, beispielsweise auf einer Membrane für eine Überdachung, angeordnet ist, wird unter Zwischenschaltung einer Binde- oder Haftschicht großflächig auf die Gewebebahn (64) auflaminiert. Mehrere derartige photovoltaische Elemente werden miteinander durch Zellenverbinder aus faltbaren metallischen Leiterstreifen oder aus elektrisch leitfähigen Elastomeren verbunden.

EP 0 493 307 A2

Fig.12

Die Erfindung betrifft ein photovoltaisches Element mit zwischen zwei Schichten vorgesehener Sperrschicht, die insbesondere zum Trennen darin entstandener oder in sie eindiffundierter Ladungsträgerpaare od. dgl.vorgesehen ist, wobei das photovoltaische Element auf einem Träger aus elastischem Werkstoff, beispielsweise auf einer Membrane oder einem Zeltstoff, angeordnet ist. Zudem erfaßt die Erfindung eine Anwendung des photovoltaischen Elementes sowie ein Verfahren und eine Vorrichtung zu dessen Herstellung.

Die DE-OS 34 27 574 beschreibt eine Vorrichtung zum Beschatten von Flächen, insbesondere zur Beschattung begehbarer Plätze od.dgl., mit zumindest einer auf Stützen od.dgl. Tragelementen in Abstand zu der zu beschattenden Fläche aufgespannten Dachhaut od. dgl. flexiblem Tragwerk, an dem photovoltaische Elemente als Schicht oder als gegebenenfalls zueinander bewegbare Siliziumkristalle vorgesehen sind. Photovoltaische Elemente weisen einen mehrschichtigen Aufbau auf; eine Sperrschicht trennt Systeme aus Halbleiter/Halbleiter, Halbleiter/Elektrolyt, Halbleiter/Metall oder Metall/Elektrolyt. In der Sperrschicht oder in ihrer unmittelbaren Umgebung entsteht ein sogenannter Photoeffekt; durch Lichteinfall erzeugte, aus der Umgebung in diese Sperrschicht eindiffundierte oder in der Sperrschicht entstandene Ladungsträgerpaare (Excitonen) od. dgl. werden im elektrischen Feld der Sperrschicht getrennt, wodurch eine nutzbare Spannung entsteht. Beispielsweise kann einer -- zwischen einer oberen negativ dotierten (etwa Silizium mit Phosphor-Atomen) und einer unteren (Bor-Atome) positiv dotierten Schicht aufgebauten -- elektrischen Sperre über Metallkontakte unmittelbar Gleichstrom entnommen werden, den man dann durch Inverter an das Stromnetz anpassen kann. Aus diesem Grunde auch sind solche photovoltaischen Elemente direkt an Stromleitungen angeschlossen.

Ein photovoltaisches Solarmodul ist gemäß DE-OS 31 42 129 durch ein verzinktes Eisendrahtgewebe oder Eisendrahtnetz verstärkt, das eine Lackschicht trägt und mit dem die Solarzelle umhüllenden Kunststoff -- unter Zwischenschaltung einer Mehrschichtfolie als Dampfdiffusionssperre -- verbunden ist. Im Kunststoff können ein Glasgewebe sowie die elektrischen Leitungen verlaufen. Dieses Solarmodul soll außerhalb des Bereiches seiner durch steifes Material hinterfütterten Solarzelle gekrümmten starren Flächen wie unebenem Boden, Autodächern, Felswänden, Hausfronten o.dgl. angepaßt werden können, diese Anpassung an die Krümmung erfolgt also formgebend ein einziges Mal, nämlich beim Auflegen. Für bewegte gekrümmte Flächen sind derartige Solarmodule ebenso ungeeignet wie photovoltaische Schichten aus amorphem Silizium oder aus Kadmiumderivaten etwa nach US-PS 34 11 050.

Diese in Solarmodulen zusammengefaßten Elemente werden nach DE-OS 34 27 574 auf schwingende großflächige Überdachungssysteme aufgebracht. Aus den besonderen Gegebenheiten solcher als "Leichte Flächentragwerke" bezeichneten Bauten ergeben sich spezifische Anforderungen an die Befestigung der Solarmodule. Mit der IEC 504 der Kommission der Europäischen Gemeinschaft werden an -- für den Einsatz von Solarmodulen geeignete -- aufgeständerte Dachflächen folgende durch Schnee- und Windlast bedingte Eckwerte vorgegeben:

Sogkräfte 2400 N/m^ 2;

Druckkräfte 5400 N/m^2;

Scherungskräfte bei 60° - Anstellwinkel 5000 N/m^2.

Ein weiträumiges photovoltaisches Modul besteht nach US-PS 47 13 492 aus mehreren aneinandergelenkten Solarflächen und kann gefaltet oder gerollt werden. Es handelt sich um ein amorphes Modul mit Wirkungsgraden im Bereich von 4 bis 5 %.

Da der Stand der Technik entweder einzelne starre Solarmodule aus kristallinen Solarzellen oder kleine flexible Module vorsieht, hat sich der Erfinder das Ziel gesetzt, ein photovoltaisches Elemente sowie ein Verfahren dafür zu schaffen, mit dem dieses Element in Gewebemembranen integriert werden kann. Es soll eine unlösbare und dauerhafte Verbindung zwischen starren Solarzellen und flexiblen Gewebemembranen -- insbesondere für photovoltaisch genutzte Membranbauten, Beschattungsanlagen, Überdachungen od. dgl. -- unter Beibehaltung der Funktionsfähigkeit beider Ausgangsmaterialien entstehen. Außerdem soll eine Vorrichtung zur Verfahrensdurchführung sowie eine besondere Verwendung des photovoltaischen Elements angeboten werden.

Zur Lösung dieser Aufgabe führt die Lehre des Patentanspruches 1. Weitere vorteilhafte Ausgestaltungen sind den Unteransprüchen zu entnehmen, insbesondere den Ansprüchen 15,16 oder 23.

Es wird also ein für das Auflaminieren auf beschichtete Gewebebahnen besonders geeigneter Aufbau eines photovoltaischen Moduls vorgestellt. Die Solarzellen werden dazu je nach elektrischen Erfordernissen zu Modulen zusammengeschaltet. Der Kontaktierung der Zellen untereinander dienen erfindungsgemäß Zellenverbinder aus gefalteten metallischen Leiterstreifen bzw. aus leitfähigen Elastomeren.

Dank einer besonderen Laminiervorrichtung kann im Rahmen der Erfindung eine fortlaufende flächige Laminierung von Solarmodulen für großflächige Überdachungen aus langen Bahnen und großen Gewebestücken mit vielfältiger Doppelnutzung erfolgen, wobei die Ränder der Bahn über Dichtflächen des Vakuumlaminators hinausragen. Die Größe der Gewebebahnen ist im Prinzip frei wählbar.

Zur Gewährleistung einer hohen Haftung des Modulaufbaus auf der tragenden Gewebebahn wird deren Deckschicht vor dem Laminiervorgang zur Erhöhung der Oberflächenspannung koronabehandelt. Die Koronabehandlung erfolgt während des Durchlaufs durch ein Elektrodensystem und eine als Walze ausgebildete Gegenelektrode bei 20 kV und 60 kHz. Die zu erreichende Oberflächenspannung wird dazu auf ca. 46 mN/m eingestellt.

Die dauerhafte elastische Verbindung zwischen Solarzelle und Gewebebahn entsteht durch eine adhäsive thermoplastische Polymerschicht, die insbesondere elastomere Copolymere aus Ethylen und Vinylacetat (EVA), EVB, Silikone od. dgl. aufweist. Bevorzugt kommt die Polymerschicht in Form von Folie zur Anwendung. Zur flächigen Stabilisierung der spröden Solarzelle erfolgt eine Hinterlegung mit einer Scheibe aus einem Werkstoff hohen Elastizitätsmoduls, wie etwa Metall oder verstärktem Kunststoff, oder eine Stützung nach vorn -- also zur Lichteinfallseite hin -- durch eine dünne Glasscheibe. Nach vorn wird dieses Element weiterhin durch eine Polymerfolie gegen Umwelteinflüsse geschützt. Zur Verbesserung der Haftung wird auch diese Folie auf der nach innen gerichteten Seite koronabehandelt.

Wie bereits erwähnt, ist das Laminat in Form eines Sandwiches aus den beschriebenen Schichten sowie zwischen jedem dieser Funktionselemente einer verbindenden, elastischen Polymerschicht aufgebaut. Dieser komplett geschichtete Modulaufbau wird auf das Zeltgewebe od. dgl. Werkstoffbahn aufgebracht und im Vakuumlaminator bei ca. 10 mbar und 150° C laminiert.

Bei dem für dieses Verfahren eingesetzten Laminator bevorzugter Ausführung trennt die Gewebebahn oder Dachhaut zwei Vakuumkammern. Laminatorober- und -unterteil verfügen vorteilhafterweise jeweils über eigene Dichtrahmen aus hitzebeständigem Elastomer, welche die Vakuumabdichtung zur dazwischenliegenden Gewebebahn während des Laminierprozesses gewährleisten. Durch Belüftung der oberen Vakuumkammer während des Aufheizvorganges wird die Gewebe- oder Trägerbahn auf den Solarzellenaufbau gepreßt und beide werden fest miteinander verbunden.

Nach erfolgter Laminierung wird der Laminator geöffnet und die Trägerbahn in Längsrichtung verschoben, um die anschließende Laminierung des nachfolgenden Abschnittes durchführen zu können. Das Verfahren wiederholt sich periodisch, und es entsteht eine fortlaufend beschichtete Gewebebahn.

Von eigenständig erfinderischer Bedeutung ist die Lösung der Aufgabe, den Wirkungsgrad photovoltaischer Anlagen durch deren Anpassung an den Sonnenverlauf zu verbessern.

Erfindungsgemäß sollen in größeren Photovoltaik-Anlagen viele Solarmodule in Reihe geschaltet werden, um die Stromverluste zu minimieren. Die Leistung wird dann durch eine höhere Spannung übertragen. Von vornherein sind in jedem Solarmodul etwa vierzig Zellen in Reihe geschaltet und deren Fertigungstoleranz im Wirkungsgrad bedingt gewisse Mängel. Diesen modulseitigen Nachteilen werden jene der Reihenschaltung überlagert. Aus diesem Grund ist bei größeren Anlagen darauf zu achten, daß die Solarmodule sortiert in Reihe geschaltet werden. Demgegenüber wird durch die erfindungsgemäße Wahl einer kleinen Anlagenspannung das Problem der Fehlanpassung (Miss-Matching) von in Reihe geschalteten Modulen unterschiedlicher Anstellwinkel weitgehend verhindert.

Leichte Flächentragwerke weisen immer Krümmungen auf, so daß hier durch in Reihe geschalteten Solarmodule mit unterschiedlichem Anstellwinkel -- und damit Modulen mit unterschiedlichem Lichteinfall -- zusätzliche Fehler hervorgerufen werden.

Da also Solarmodule auf gekrümmten Leichten Flächentragwerken unterschiedlich stark bestrahlt werden, soll erfindungsgemäß ihre Ausgangsspannung durch eine Reihenschaltung von mehreren -- möglichst räumlich gleichgerichteten --Solarmodulen erhöht werden. Zur optimalen Ausnutzung eines Solargenerators muß der Arbeitspunkt immer im sog. Maximum Power Point (MPP) liegen.

Weiterhin besteht die Gefahr, daß das Regelsystem die Kennlinie im Bereich eines anderen Maximums abtastet und den MPP-Punkt mit der max. Leistung nicht erreicht.

Im Rahmen der erfindungsgemäßen Lehre werden in einer photovoltaischen Anlage Solarmodule mit annähernd gleicher Ausrichtung zu Strängen zusammengeschaltet. Zudem soll die Anlage in Bereiche aufgeteilt und jedem Bereich ein eigener MPP-Regler zugeordnet werden; für jeden Bereich stellt sich der optimale Arbeitspunkt ein.

Mit dem MPP-Regler wird der von den Modulen gelieferte Strom "zerhackt" und über bestimmte Regelkreise entweder herauf- oder heruntertransformiert. Am Ausgang dieser Regelungen wird immer eine konstante Spannung verlangt, um entweder eine Batterie zu laden oder diese konstante Gleichspannung über allgemein bekannte Wechselrichter in Wechselspannung zu verwandeln und eine sogenannte Netzrückspeisung aufzubauen.

MPP-Regelungen arbeiten nach dem Prinzip einer kontinuierlichen Leistungsmessung. Es wird irgendein Arbeitspunkt auf der Kennlinie angefahren und kurze Zeit später ein weiterer Punkt auf der Kennlinie (Zeitbereich Millisekunden bis Minuten). Ist die Leistung im zweiten Arbeitspunkt größer als im ersten gemessenen Punkt, wird in der gleichen Richtung ein neuer Arbeitspunkt angewählt und sodann wieder verglichen. Ist die Leistung im ersten Arbeitspunkt größer, wird in die andere Richtung ein weiterer Punkt abgetastet. Auf diese Weise kommt es zu einem kontinuierlichen Maximum-Power-Point-Tracking. Derartige Geräte sind Stand der Technik und sollen nach der Erfindung optimiert eingesetzt werden, um das bei Aufständerungen auftretende Problem in Reihe geschalteter Module mit unterschiedlichem Anstellwinkeln zu minimieren. Zusätzlich wird durch diese Maßnahme bei konventionellen Anlagen und gewissen Verschattungsproblemen eine verbesserte Energieausbeute erreicht.

Durch die Aufteilung der räumlich gekrümmten bewegbaren Tragfläche in Bereiche kann die gesamte Anlage dem Sonnenverlauf angepaßt werden; vormittags arbeitet der Bereich mit östlicher Ausrichtung im optimalen Arbeitspunkt, während der Mittagszeit wird der mittlere Bereich hervorragend bestrahlt, und nachmittags liefert der nach Westen gerichtete Bereich die größte Leistung. Keiner dieser Bereiche wird -- da elektrisch unabhängig -- von den anderen beeinflußt.

Die Ausgangsspannungen der einzelnen MPP-Regler können auf einen Wert festgelegt werden und somit einen gemeinsamen Verbraucher bzw. Batteriespeicher speisen. Ein herkömmlicher MPP-Regler besteht aus mehreren Leistungsteilen, weshalb nur zusätzliche Regeleinheiten nötig wären.

Bei teilweise Beschattungen (durch Bäume, Gebäude usw.) würde nur der betreffende Bereich beeinflußt; die übrigen Bereiche arbeiten weiterhin im MPP-Punkt und liefern die maximale Leistung.

Es hat sich gezeigt, daß eine derartige Anlage mit erfindungsgemäß unterschiedlich ausgerichteten Solarmodulen -- für die selbständig Schutz begehrt wird -- dann als optimiert angesehen werden kann, wenn

die Anzahl der in Reihe geschalteten Solarmodule möglichst klein gehalten ist;

die Anlage in kleine parallele geschaltete Bereiche aufgeteilt wird, die den Sonnenverlauf berücksichtigen;

diese parallel geschalteten Bereiche durch MPP-Regelungen für jeden Bereich weitergehend optimiert werden.

Insgesamt wird mit der vorstehenden Lehre die Wirtschaftlichkeit von photovoltaischen Anlagen erheblich verbessert.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in

Fig. 1 bis Fig. 4: vier Graphiken mit unterschiedlichen Kennlinien;

Fig. 5: die Draufsicht auf ein Seilnetz als Dachfläche mit darauf angeordneten Solarmodulen in vier Gruppen;

Fig. 6: die Seitenansicht einer als Wellenarkade aufgespannten Dachhaut;

Fig. 7: die Draufsicht auf Fig. 6 mit auf der Dachhaut vorgesehenen Solarmodulen in drei Gruppen;

Fig. 8: eine Seitenansicht zu Fig. 6, 7 (um 90° gedreht);

Fig. 9, 10: vergrößerte Details aus Seilnetzen im Schnitt mit einem Teil eines Solarmoduls;

Fig. 11: ein vergrößertes Detail aus einer Dachhaut im Schnitt;

Fig. 12: die Draufsicht auf ein Solarmodul;

Fig. 13: einen Schnitt durch einen Teil einer Dachhaut;

Fig. 14: eine Anordnung zweier Solarmodule in Draufsicht;

Fig. 15, 16: schematische Schnitte durch Solarmodule mit unterschiedlichen Trag- und Deckschichten;

Fig. 17: den Querschnitt durch eine Vorrichtung zum Herstellen von Gewebebahnen mit Solarmodulen.

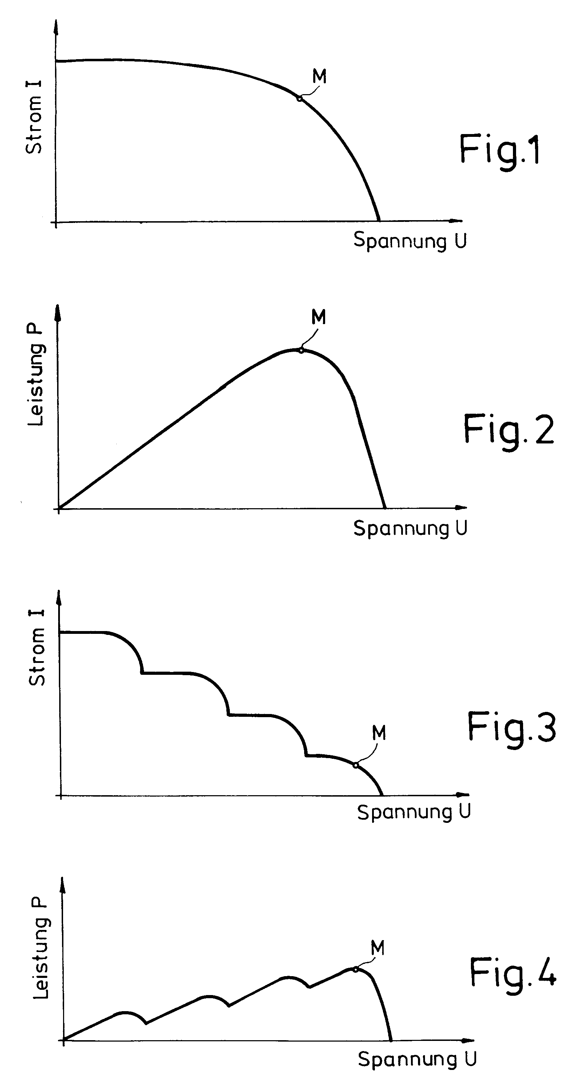

Fig. 1 zeigt in einem ebenen Koordinatensystem mit der Ordinate I (= elektrische Stromstärke) über der Abszisse U (= elektrische Spannung) die Gesamtkennlinie einer Gruppe von gleichmäßig ausgerichteten Solarmodulen. Mit M ist der sog. Maximum Power Point (= MPP) bezeichnet.

In Fig. 2 ist über der elektrischen Spannung U die Leistung P für gleichmäßig ausgerichtete Solarmodule aufgetragen mit dem Punkt M im Kurvenmaximum; dieser ist bei optimaler Ausnutzung des Solargenerators die Lage des Arbeitspunktes für die verstellbaren Solarmodule. Dazu tastet ein nicht dargestelltes Regelsystem eines MPP-Reglers die Kennlinie des Solargenerators ab. Aus den jeweiligen Strom- und Spannungswerten wird die Leistung errechnet. Ist die Leistung beim nächsten abgetasteten Punkt größer, wird die Abtastrichtung beibehalten; ist sie kleiner, wird in die Gegenrichtung abgetastet und so der MPP-Punkt gefunden sowie festgehalten.

Die der Darstellung in Fig. 1 entsprechende Gesamtkennlinie für unterschiedlich ausgerichtete Solarmodule zeigt Fig. 3; in diesem Falle wird die Gesamtkennlinie verformt. Im MPP-Punkt dieser Zusammenschaltung ist die Leistung kleiner als bei gleichmäßig ausgerichteten Solarmodulen, was der Leistungsverlauf der Fig. 4 verdeutlicht.

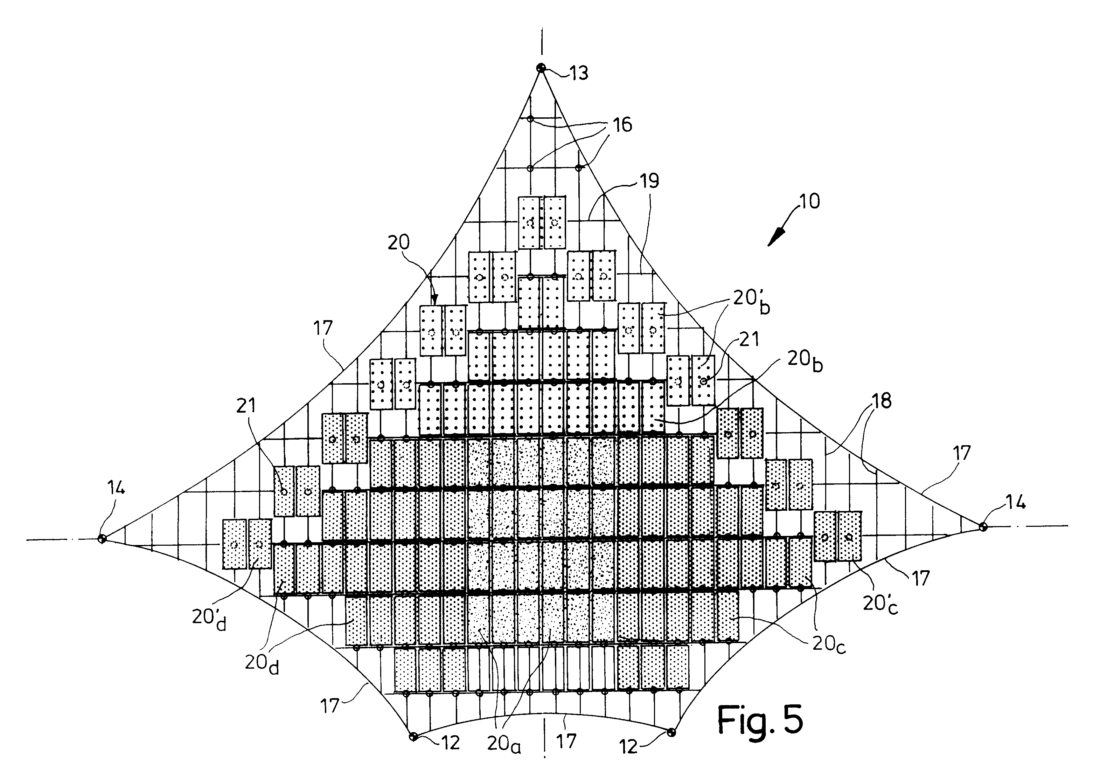

Um Kennlinien nach den Fig. 1, 2 zu erzielen, sind gemäß Fig. 5 auf einem -- zwischen zwei Hochpunkten 12, einem Hochpunkt 13 größeren Bodenabstandes und zwei Tiefpunkten 14 -- gekrümmt aufgespannten Seilnetz 10 an Seilnetzknoten 16 Solarmodule 20 festgelegt. Die Lage dieser Seilnetzknoten 16, von denen nur einige wenige erkennbar sind, wird von sich innerhalb von Randseilen 17 kreuzenden Innenseilen 18, 19 bestimmt.

Die Solarmodule 20 sind jeweils in Bereiche $20_a$ bis $20_d$ zusammengefaßt, wobei der zentrale Bereich $20_a$ -- und großteils auch der Bereich $20_b$ -- zum Zenit weist, somit vor allem Mittagssonne empfängt. Hingegen sind die Bereiche $20_c$ bzw. $20_d$ hier mehr dem Osten bzw. dem Westen zugeordnet, nehmen also Morgen- bzw. Abendsonne auf. Die den Randseilen 17 zwischen den Spannpunkten 13 und 14 benachbarten Solarmodule $20'_b$, $20'_c$, $20'_d$ sind mittels zentrischer Verbindungsglieder 21 an die Seilnetzknoten 16 angeschlossen, die anderen Solarmodule $20_a$ bis $20_d$ jeweils einem von vier Seilnetzknoten 16 bestimmten Maschenfeld zugeordnet, d.h. die Schmalseiten ihrer -- in Fig. 5 nicht verdeutlichten -- Modulrahmen verlaufen hier oberhalb der Innenseite 19 und liegen jeweils mit der Längsachse auf einem Seilnetzknoten 16.

Nicht erkennbar sind auch jeweils zumindest vier Solarmodule 20 eines Bereiches untereinander verbindende Stromleitungen und deren Anschlüsse an einen Stromaufnehmer.

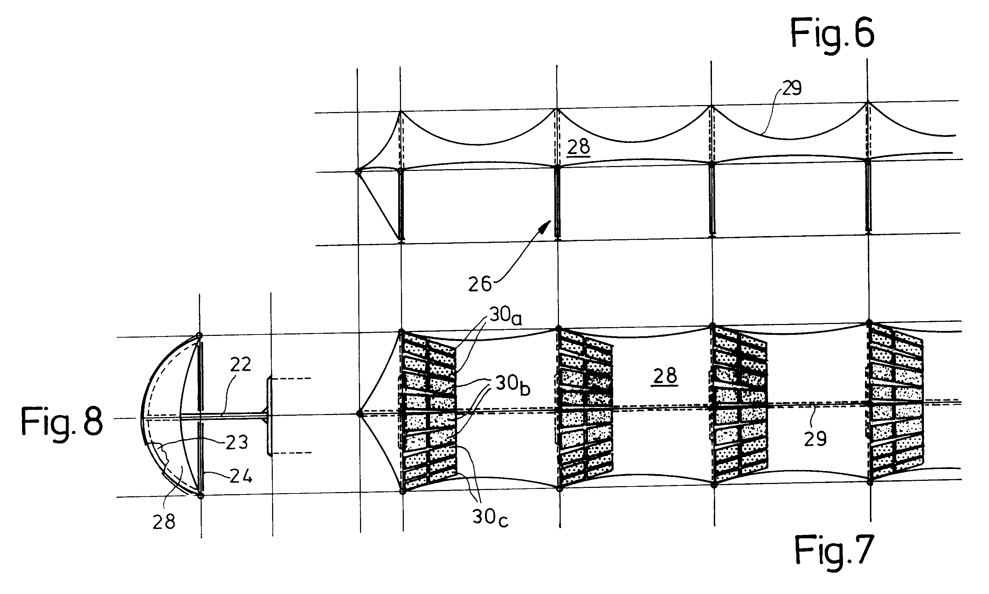

Sowohl bei dieser als auch bei einer weiteren Anlage nach Fig. 6 bis 8 ist eine Arbeitsspannung von 48 V festgelegt, wozu immer vier Solarmodule 20 in Reihe geschaltet sind.

Eine sog. Wellenarkade nach Fig. 6 bis 8 besteht aus einem -- vertikale Ständer 22 und Spannbogen 23 an Horizontalträgern 24 enthaltenden -- Traggerüst 26 und einer daran aufgespannten Dachhaut 28, die eine kettenlinienartige Kammlinie 29 bildet. Auf dieser Dachhaut 28 sind auf der nach Süden gerichteten Seite des Spannbogens 23 Solarmodule 30 in drei Gruppen $30_a$, $30_b$, $30_c$ angeordnet, von denen die mittlere Gruppe $30_b$ vor allem mittags mit Sonnenenergie beaufschlagt ist, die flankierenden Gruppen $30_a$ bzw. $30_c$ aber vor dem Mittag bzw. nachmittags.

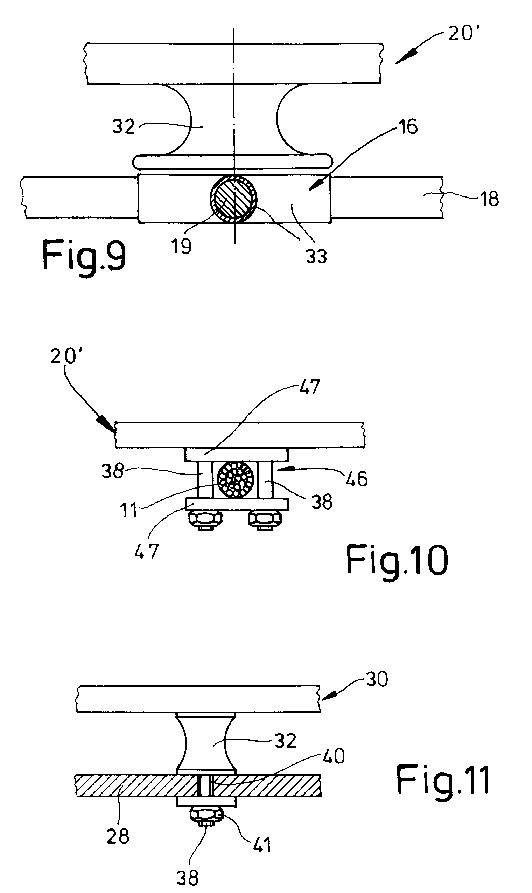

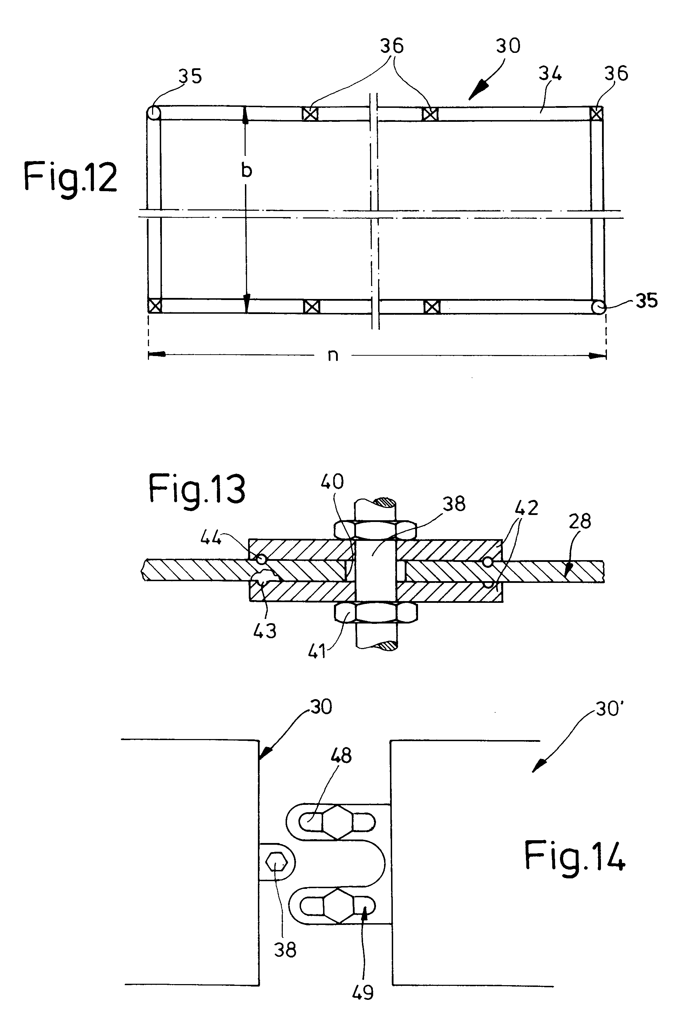

Das Solarmodul 20' der Fig. 9 kann am Seilnetz 10 beispielsweise durch einen Kunststoffsockel 32 festgelegt werden, der an Hülsen 33 des Seilnetzknotens 16 angeschraubt wird und als Puffer wirkt. Dessen Fallhärte beträgt beispielsweise für ein Solarmodul 20 der Länge n von 1000 mm und der Breite b von 500 mm gemäß Fig. 12 etwa 20 bis 30 (Shore A).

Fig. 10 zeigt ein Solarmodul 20' auf einem Seil 11 eines Seilnetzes 10; sie ist am Seil 11 durch eine Seilklemme 46 mit beidseits des Seiles 11 angebrachten, durch Schrauben 38 verbundenen Klemmplatten 47 festgelegt. Diese Klemmverbindung 11/46 rutscht ab einer auf das Solarmodul 20' einwirkenden definierten Kraft.

Um Scherkräfte aufnehmen zu können, soll einer der Befestigungspunkte starr sein, wohingegen die anderen Befestigungspunkte nur Druck- oder Sogkräfte aufnehmen. Durch die Kombination fester Punkte mit gleitenden Bereichen -- an Seil- oder Rutschklemmen 46 -- erfolgt ein Ausgleich der Bewegungen der Unterkonstruktion 10, 28 gegenüber dem Solarmodul 20, 30.

Der Solarmodul 30 nach Fig. 11 ist unter Zwischenschaltung oben beschriebener Kunststoffsockel 32 auf einer membranartigen Dachhaut 28 mittels Schrauben 38 festgelegt, die ausgestanzte Löcher 40 sowie Unterlegplatten 39 durchsetzen und über eine Mutter 41 angezogen werden können.

So kann ein Modulrahmen 34 des in Fig. 12 in Draufsicht gezeigten Solarmoduls 30 an den Stellen 35 mit der hier nicht gezeigten tragenden Dachhaut 28 fest verbunden, an Stellen 36 hingegen durch Rutschklemmen verschieblich gelagert sein.

Die Festlegung eines Solarmoduls 30 an der Dachhaut 28 durch eine Schraube 38 gibt skizzenhaft auch Fig. 13 wieder; die Dachhaut 28 wird um das von der Schraube 38 durchsetzte Loch 40 beidseits von zwischen den Muttern 41 liegenden Klemmplatten 42 gehalten, welche in Nuten 43 O-Ringe 44 aufnehmen. Schließlich läßt Fig. 14 zwei benachbarte Solarmodule 30, 30' erkennen, von denen der linke mit eine fixierende Schraube 38 sowie der rechte mit einer Langlöcher 48 anbietenden Rutschklemme 49 ausgestattet ist.

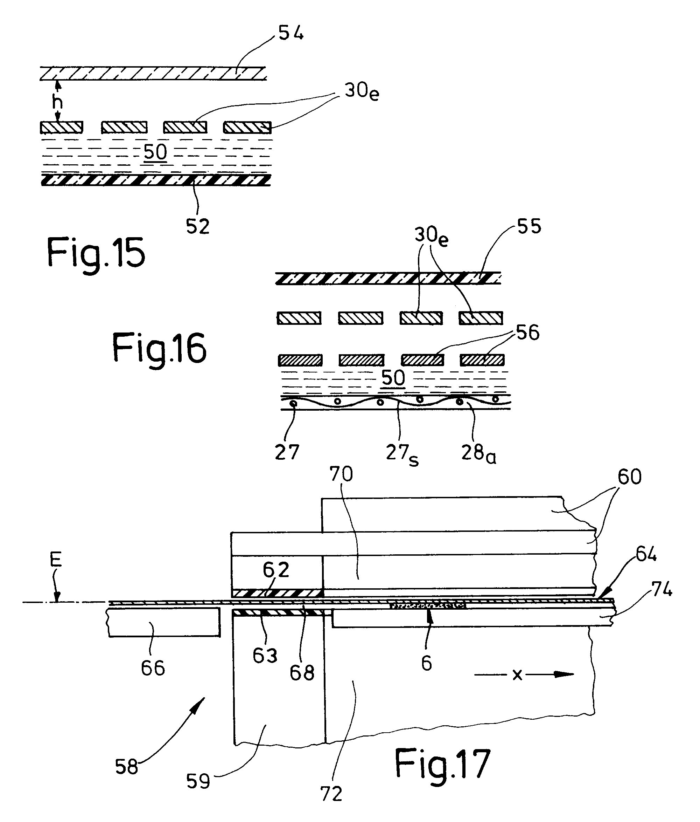

Zwei Ausführungen von Anordnungen für Solarmodule $30_e$ stellen die Fig. 15, 16 vor. Die Solarmodule $30_e$ der Fig. 15 sind mittels eines weichen Einbettmaterials 50 auf einer Glas- oder Kunststoffolie 52 festgelegt und von einer Glasfläche 54 überdeckt; die Abstände zwischen den Schichten -- beispielsweise der Abstand h zwischen der Ebene der Solarmodule $30_e$ und der Glasfläche 54 -- sind in beiden Fig. 15, 16 aus Gründen besserer Übersicht überhöht gewählt.

Die Anordnung nach Fig. 16 zeigt auf einer hochreißfesten Membrane -- mit Kette 27 und Schuß $27_s$ als Dachhaut $28_a$ -- weiches Einbettmaterial 50, dann Stabilisierungsplatten 56, denen nach oben hin die Solarmodule $30_e$ folgen. Letztere überspannt eine hochtransparente Kunststoffolie 55.

Die Solarmodule können in die Dachhaut $28_a$ flächig integriert sein.

Für das Laminieren kann ein Laminator eingesetzt werden, in dem auf eine von einem Laminatoroberteil überspannte Heizplatte eine Gewebeschicht als Laminatträger gelegt wird. Auf diesem ruht ein Laminat mit einem Schichtaufbau, wie er vorstehend für photovoltaische Elemente beschrieben worden ist; zwischen einer Außenschichtpaarung aus einer Halbleiterschicht einerseits sowie einem Elektrolyten oder einem Metall anderseits bzw. zwischen Metall und einem Elektrolyten ist eine Sperrschicht zum Trennen von Ladungsträgerpaaren vorgesehen. Über den im Laminatorunterteil ruhenden Gewebeabschnitt und das aufgelegte Laminat wird eine Silikonmatte als Dichtung gespannt, deren Randbereich zwischen Rahmenteilen klemmend gehalten wird; das untere Rahmenteil bestimmt eine Öffnungsebene des beschriebenen Laminators, die unterhalb jener Silikonmatte und zu ihr in Abstand verläuft.

Das durch die Laminierung bekannter Art bei etwa 10 mbar und 150° C in Vakuum entstandene Bauteil aus dem zuvor koronabehandelten Gewebeabschnitt sowie dem mehrschichtigen Laminat wird durch Zellenverbinder aus gefalteten metallischen Leiterstreifen bzw. elektrisch leitfähigen Elastomeren zu Modulen zusammengeschaltet.

Ein Laminator 58 mit Laminatorsockelteil 59 und Laminatoroberteil 60 ist in Fig. 17 angedeutet; mit diesem Laminator 58 wird eine durchlaufende Gewebebahn 64 laminiert; diese durchwandert -- von einer Zuführablage 66 kommend -- einen zwischen Laminatorsockel 59 und Laminatoroberteil 60 in deren Öffnungsebene E bestehenden Spalt 68, der nach oben und unten jeweils von einem Silikondichtrahmen 62, 63 begrenzt ist.

Die aufgespannte Gewebebahn 64 trennt eine obere Vakuumkammer 70 von einer unteren Vakuumkammer 72. Durch Belüften der oberen Vakuumkammer 70 während des Aufheizvorganges wird die Gewebebahn 64 auf den -- von einer Heizplatte 74 gehaltenen -- beschriebenen Sandwichaufbau des Laminats 61 gepreßt und mit diesem verbunden.

Nach der Laminierung wird gekühlt, der Laminator 58 geöffnet und die Träger- oder Gewebebahn 64 um eine Laminatorlänge für einen neuen Laminierungsabschnitt verschoben (Pfeil x).

Mit dem beschriebenen Laminator 59 ist nicht nur möglich, Bahnen großer Länge zu laminieren, um in großen Flächen aufspannbare Solarmodule zu erzeugen. Darüberhinaus können mit diesem Verfahren auch ganze -- aus Bahnen zusammengeschweißte -- Zelthäute mit Solarmodulen $30_c$ ausgestattet werden.

## Patentansprüche

1. Photovoltaisches Element mit zwischen zwei Schichten vorgesehener Sperrschicht zum Trennen darin entstandener oder in sie eindiffundierter Ladungsträgerpaare od. dgl.,

   dadurch gekennzeichnet,

   daß zumindest ein photovoltaisches Element unter Zwischenschaltung einer Binde- oder Haftschicht großflächig auf eine Gewebebahn auflaminiert ist.

2. Photovoltaisches Element nach Anspruch 1, dadurch gekennzeichnet, daß es mit Zellenverbindern in Form von ausfaltbaren metallischen Leiterstreifen oder aus elektrisch leitfähigen Elementen an wenigstens ein anderes Element entsprechenden Schichtaufbaus angeschlossen ist.

3. Photovoltaisches Element nach Anspruch 1 oder 2, dadurch gekennzeichnet, daß die Binde- oder Haftschicht aus adhäsiven, thermoplastischen Polymeren besteht und/oder daß die Binde- oder Haftschicht als Folie ausgebildet ist.

4. Photovoltaisches Element nach einem der Ansprüche 1 bis 3, dadurch gekennzeichnet, daß es lichtseitig von einer transluzenten bzw. transparenten Schicht (54, 55) überdeckt oder lichtseitig von einer Polymerfolie abgedeckt ist.

5. Photovoltaisches Element nach einem der Ansprüche 1 bis 4, dadurch gekennzeichnet, daß zumindest eine Oberfläche der Gewebebahn (64) oder die zum Schichtaufbau weisende Fläche der Polymerfolie koronabehandelt ist.

6. Photovoltaisches Element nach wenigstens einem der Ansprüche 1 bis 5, dadurch gekennzeichnet, daß es an seiner der Glasschicht (54) bzw. der Polymerfolie (55) fernliegenden Fläche mit wenigstens einer Scheibe (56) aus einem Werkstoff hohen Elastizitätsmoduls hinterlegt ist, wobei gegebenenfalls die Scheibe (56) eine Stabilisierungsplatte ist, welche einer Seite des photovoltaischen Elements (30e) zugeordnet ist, von dem mehrere photovoltaische Elemente nebeneinander in etwa einer Ebene vorgesehen sind.

7. Photovoltaisches Element nach wenigstens einem der Ansprüche 1 bis 6, dadurch gekennzeichnet, daß es mit anderen photovoltaischen Elementen (20,30) etwa gleicher Ausrichtung in Reihe geschaltet und mit einem Regelsystem verbunden ist.

8. Photovoltaisches Element, insbesondere nach einem der Ansprüche 1 bis 7, dadurch gekennzeichnet, daß es mit anderen photovoltaischen Elementen (20,30) etwa gleicher Ausrichtung jeweils einem Bereich zugeordnet ist und letztere von der Einfallsrichtung des aufzunehmenden Sonnenlichtes in Abhängigkeit vom Sonnenstand bestimmt sind, wobei bevorzugt die Bereiche parallel geschaltet sind.

9. Photovoltaisches Element nach Anspruch 7 oder 8, gekennzeichnet durch Zuordnung eines MPP-Regler zu einer Gruppe oder einem Bereich.

10. Photovoltaisches Element nach einem der Ansprüche 7 bis 9, dadurch gekennzeichnet, daß die Ausgangsspannungen der MPP-Regler auf einem Wert festgelegt sind und einen gemeinsamen Speicher speisen.

11. Verwendung der Elemente nach wenigstens einem der Ansprüche 1 bis 10 auf langen Trägerbahnen aus flexiblem Werkstoff für die Herstellung von begrenzt flexiblen Überdachungen wie Zeltdächern od. dgl.

12. Verfahren zum Herstellen eines photovoltaischen Elements mit zwischen zwei Schichten vorgesehener Sperrschicht zum Trennen darin entstandener oder in sie eindiffundierter Ladungsträgerpaare od. dgl., insbesondere nach Anspruch 1 und/oder zur Verwendung gemäß Anspruch 11, dadurch gekennzeichnet, daß das photovoltaische Element unter Zwischenschaltung einer Bindeoder Haftschicht aus einem Polymer auf ein Gewebestück od. dgl. flexiblen Träger auflaminiert wird.

13. Verfahren nach -Anspruch 12, dadurch gekennzeichnet, daß das photovoltaische Element auf einen bahnförmigen flexiblen Träger abschnittsweise fortlaufend auflaminiert wird, und/oder daß mehrere photovoltaische Elemente als Laminat durch flexible elektrische Verbindungen in einem periodischen Laminierprozeß zusammengefügt sowie fortlaufend mit der Oberfläche der flexiblen Gewebebahn dauerhaft verbunden werden.

14. Verfahren nach Anspruch 12 oder 13, dadurch gekennzeichnet, daß die Haftseite des bahnförmigen flexiblen Trägers vor dem Laminiervorgang koronabehandelt wird, wobei bevorzugt die Koronabehandlung während eines Durchlaufes durch ein Elektrodensystem bei etwa 20 kV und etwa 20 kHz durchgeführt wird.

15. Verfahren nach einem der Ansprüche 12 bis 14, dadurch gekennzeichnet, daß die zu erreichende Oberflächenspannung auf etwa 46 mN/m eingestellt und/oder das Laminieren bei etwa 10 mbar und 150° C durchgeführt wird.

16. Vorrichtung zur Durchführung des Verfahrens nach wenigstens einem der Ansprüche 12 bis 15, gekennzeichnet durch einen Laminator (58) mit in einem Unterteil (59) vorgesehener Heizplatte (74) sowie einer über der Heizplatte verlaufenden Trennschicht (64) zwischen einer ersten und einer zweiten Laminatorkammer (70,72).

17. Vorrichtung nach Anspruch 16, dadurch gekennzeichnet, daß zumindest eine der Laminatorkammern (70, 72) als Vakuumkammer ausgebildet ist, und/oder, daß die Heizplatte (74) das Laminat (61) aufnimmt und über diesem eine Öffnungsebene (E) des Laminators (58) verläuft, die eine Durchlaufbahn für die Gewebebahn (64) bestimmt.

18. Vorrichtung nach Anspruch 16 oder 17, dadurch gekennzeichnet, daß die Gewebebahn (64) Druckmembran des Laminators (59) ist und/oder, daß die in der Öffnungsebene (E) verlaufende Gewebebahn (64) den Innenraum des Laminators (59) in die beiden Laminatorkammern (70,72) trennt.

19. Vorrichtung nach einem der Ansprüche 16 bis 18, dadurch gekennzeichnet, daß beidseits der Öffnungsebene (E) jeweils ein Dichtungsrahmen (62, 63) des Laminators (59) verläuft und beide Dichtungsrahmen unter Änderung der Weite eines Durchlaufspaltes (68) für die Gewebebahn (64) zueinander relativ bewegbar sind.

Fig.1

Fig.2

Fig.3

Fig.4

Fig. 5

EP 0 493 307 A2

Fig.6

Fig.7

Fig.8

Fig.9

Fig.10

Fig.11

Fig.12

Fig.13

Fig.14

Fig.15

Fig.16

Fig.17